# EUROPEAN PATENT APPLICATION

(11) **EP 2 557 399 A1**
(43) Date of publication of application: **13.02.2013**
(21) Application number: 11765981.3
(22) Date of filing: 07.04.2011
(51) Int. Cl.: G01D 5/245, F02D 9/10, F02D 35/00, G01B 7/30, G01D 5/12

(54) **INDUCTANCE-TYPE ROTATION ANGLE DETECTION DEVICE AND METHOD OF MOUNTING THE SAME**

(30) Priority: 08.04.2010 JP 2010089124
(71) Applicant: Hitachi Automotive Systems, Ltd., Hitachinaka-shi Ibaraki 312-8503 (JP)
(72) Inventor: HIRANUMA Daisuke, Hitachinaka-shi Ibaraki 312-8503 (JP); WATANABE Michimori, Hitachinaka-shi Ibaraki 312-8503 (JP)
(74) Representative: MERH-IP Matias Erny Reichl Hoffmann
(86) International application number: PCT/JP2011/058833
(87) International publication number: WO 2011/126081

(57) **Abstract**

An inductive non-contact rotation angle sensor used in a motor-driven throttle valve unit is such that a circuit substrate to which a stationary conductor and an electronic circuit are attached is secured to a resin cover without the use of an adhesive. A TPS substrate as the circuit substrate and an electric conductor are electrically connected to each other by pressure welding (press fit). The circuit substrate and the electric conductor can be formed of the same molding resin as a single molded body. Thus, it is not necessary to prepare another metallic conductor (a bonding wire) and also welding and soldering are eliminated. Further, since the TPS substrate is covered by the same material as cover resin, a process of bonding the substrate to the cover can be omitted, which allows for a reduction in manufacturing cost.

## Description

### Technical Field

The present invention relates to a rotation angle sensor which detects a rotational position or a rotational angle of a rotary member by detecting a rotational position of a rotating conductor in a non-contact manner. Such detection is achieved by the use of the fact that the inductance between a conductor attached to a rotating shaft of the rotary member and a coil conductor attached to a stator facing the former conductor changes according to a positional relationship between both conductors in a rotating direction.

The invention also relates to a motor-driven throttle valve unit which electrically controls the area of opening of an air passage of an internal combustion engine by the use of a motor-driven throttle valve, the throttle valve unit having the above-mentioned rotation angle sensor for rotational angle detection of the throttle valve.

### Background Art

A non-contact rotation angle sensor of this type is known from the description of JP-2003-254782-A.

It is proposed by JP-2008-96231-A to use the rotation angle sensor of this type as a rotation angle sensor of a motor-driven throttle valve control unit.

### Related Art Literature

### Patent Documents

Patent document 1: JP-2003-254782-A
Patent document 2: JP-2008-96231-A

### Summary of the Invention

### Problem to be Solved by the Invention

A conventional inductive non-contact rotation angle sensor is configured as below. A rectangular circuit substrate is secured to a front surface of a resin cover (a resin-made gear cover for e.g. a motor-driven throttle valve control unit) by bonding. Stationary conductors (an excitation conductor and a receipt coil conductor), and an input-output drive section and an electronic circuit section for control are mounted on the circuit substrate. However, many working processes are required to complete a cover assembly. Specifically, the working processes involve bonding of the circuit cover after the molding of the resin cover, and joining with the electric conductors arranged to extend in the cover for electrical connection. This poses a problem of increased manufacturing costs.

It is an object of the present invention to solve the above problem and to improve assembling workability without a reduction in accuracy.

### Means for Solving the Problem

To achieve the above object, a rotation angle sensor of the present invention is such that an resin cover includes a circuit substrate to which a stationary conductor and an electronic circuit are attached, a connector for electrically connecting with external equipment, and an electric conductor connecting a connector terminal formed on the connector with the circuit substrate; and at least a part of the circuit substrate and the electric conductor are formed as a single molded body molded by the same resin.

Preferably, the stationary conductor secured to the circuit substrate and the electric conductor are formed as a single molded body covered and molded by the same resin, and the molded body is further overmolded by a molding resin of the resin cover.

Preferably, an electric connection between the circuit substrate and the electric conductor is covered and molded by the same resin as the molded body or the resin cover.

Preferably, a resin layer covering the stationary conductor is formed to have a thickness smaller than the thickness of a resin layer covering the electric conductor.

Preferably, an electric connection between the circuit substrate and the electric conductor is connected by pressure welding (press fit).

Specifically, a motor-driven throttle valve control unit equipped with the inductive non-contact rotation angle sensor having the above features is such that a relay terminal for power supply to the motor is molded by the same molding resin as a molding resin of the resin cover and an electric conductor for power supply to the motor is formed as a single molded body together with the circuit substrate and another electric conductor.

Preferably, the resin cover functions as a housing member housing a gear mechanism for transmitting the rotation of the motor to a throttle valve.

Preferably, the rotary conductor is attached to a throttle valve shaft or a throttle gear secured to the throttle valve shaft.

### Effect of the Invention

The present invention can reduce assembly man-hours without a reduction in accuracy since it is not necessary to bond the circuit substrate to the resin cover.

The use of the rotation angle sensor of the present invention improves the control accuracy of a motor-driven throttle valve and enhances assembly performance.

### Brief Description of the Drawings

[Fig. 1]

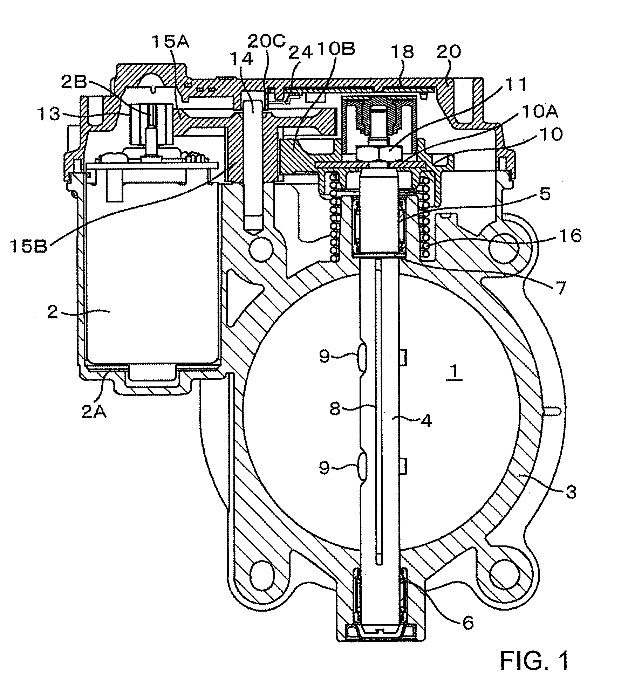

   Fig. 1 is an overall cross-sectional view of a motor-driven throttle valve unit.
[Fig. 2]

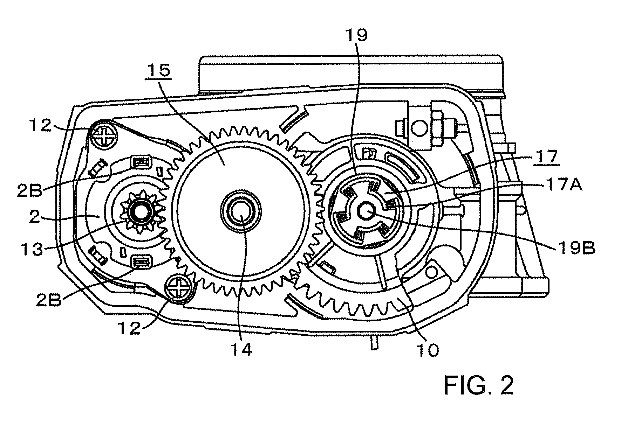

   Fig. 2 is an exploded front view of the motor-driven throttle valve unit.
[Fig. 3]

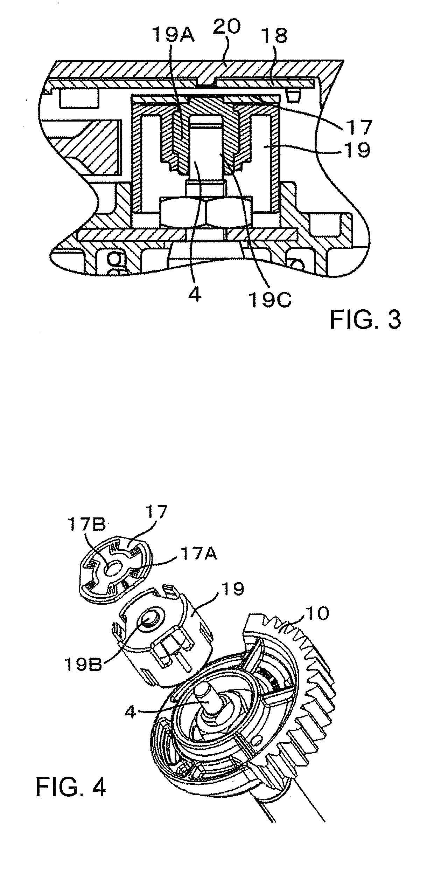

   Fig. 3 is a partial cross-sectional view of a rotating conductor of an inductive rotation angle sensor.
[Fig. 4]
   Fig. 4 is an exploded perspective view of the rotating conductor of the inductive rotation angle sensor.
[Fig. 5]

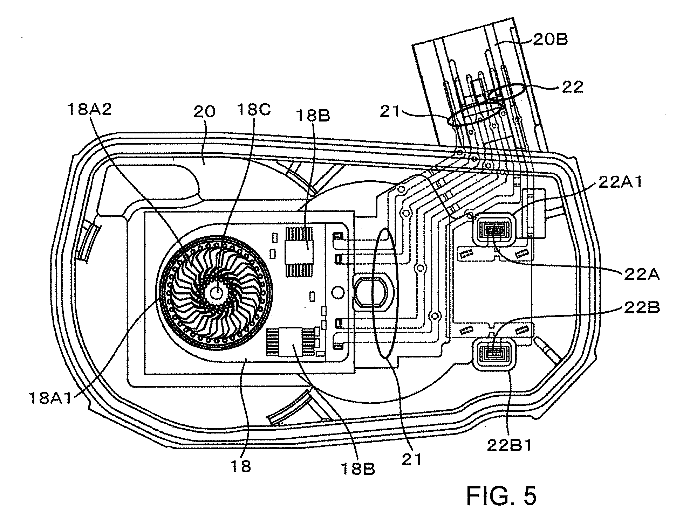

   Fig. 5 is a perspective front view of the inductive rotation angle sensor.
[Fig. 6]

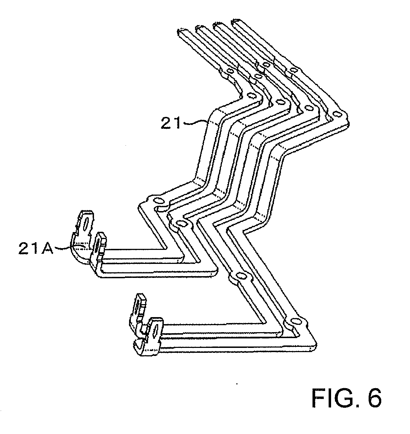

   Fig. 6 is an overall perspective view of a TPS terminal.
[Fig. 7]

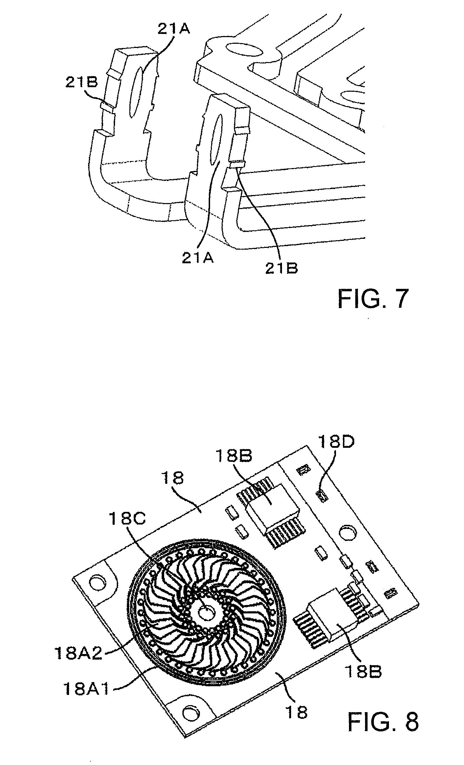

   Fig. 7 is an enlarged perspective view of a distal end of the TPS terminal.
[Fig. 8]
   Fig. 8 is an overall perspective view of a TPS substrate.
[Fig. 9]

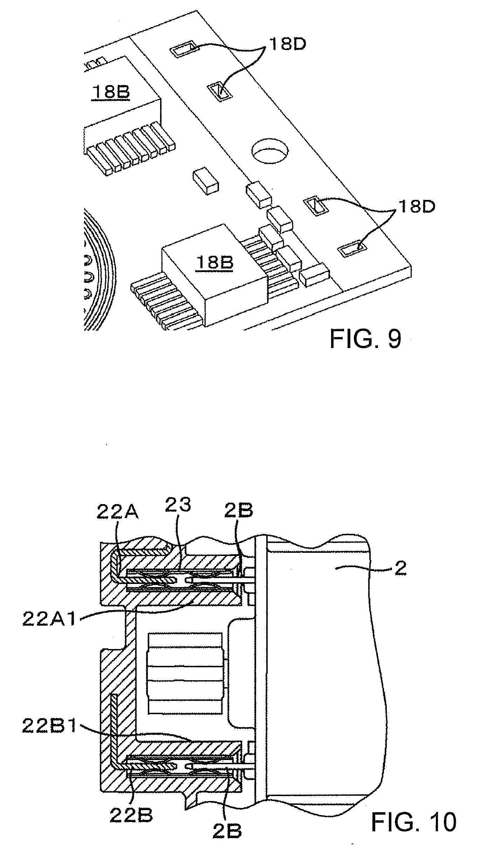

   Fig. 9 is an enlarged perspective view of a through-hole portion of the TPS substrate.
[Fig. 10]
   Fig. 10 is a partial cross-sectional view of a motor electrical junction of the motor-driven throttle valve unit.
[Fig. 11]

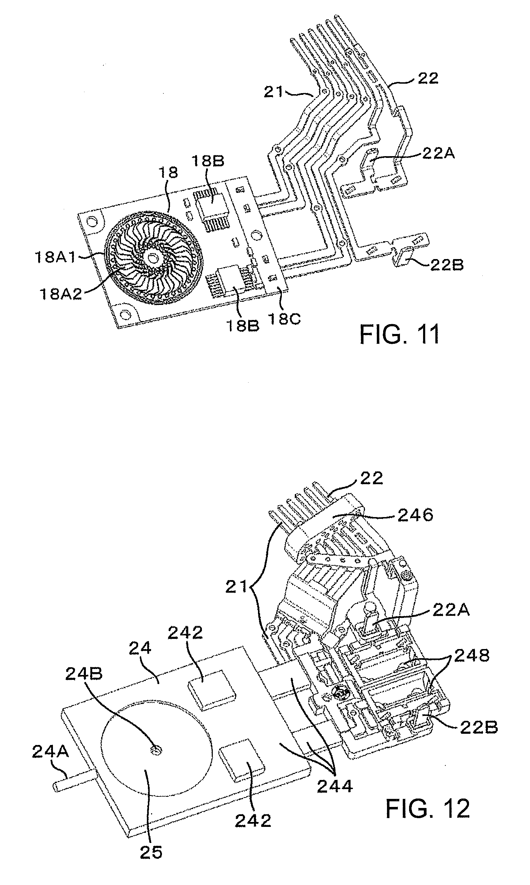

   Fig. 11 is an overall perspective view of a sub-assembly of the TPS substrate and terminals.
[Fig. 12]
   Fig. 12 is an overall perspective view of an insert molded product.
[Fig. 13]

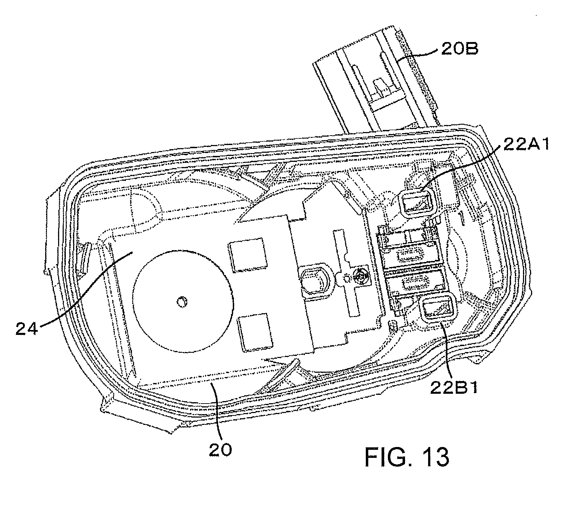

   Fig. 13 is an overall perspective view of the inductive rotation angle sensor.
[Fig. 14]

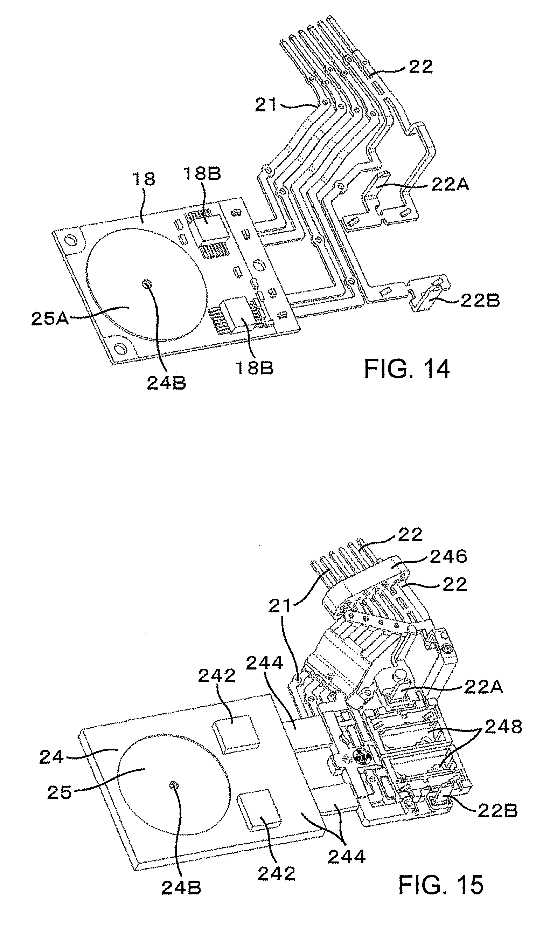

   Fig. 14 is an overall perspective view of a sub-assembly of a TPS substrate and terminals according to a second embodiment.
[Fig. 15]
   Fig. 15 is an overall perspective view of an insert molded product according to the second embodiment.
[Fig. 16]

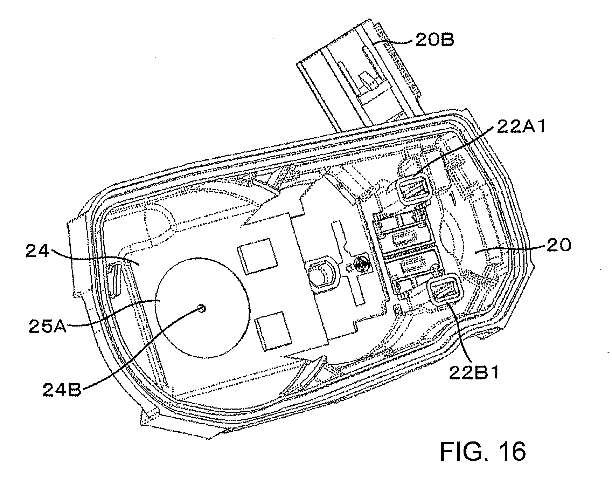

   Fig. 16 is an overall perspective view of the inductive rotation angle sensor according to the second embodiment.
[Fig. 17]

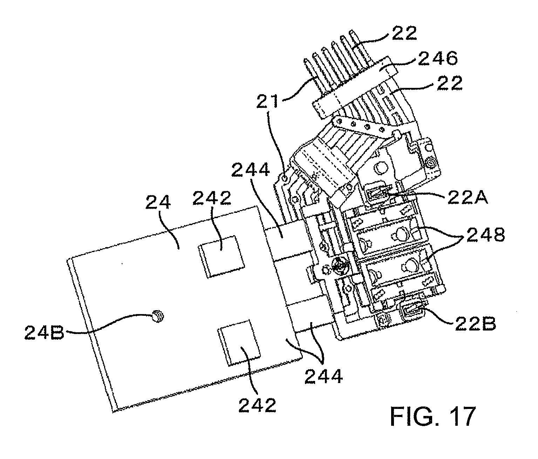

   Fig. 17 is an overall perspective view of a sub-assembly of a TPS substrate and terminals according to a third embodiment.
[Fig. 18]

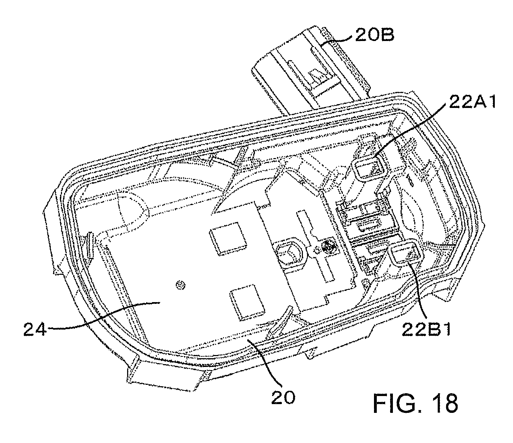

   Fig. 18 is an overall perspective view of an inductive rotation angle sensor according to the third embodiment.
[Fig. 19]

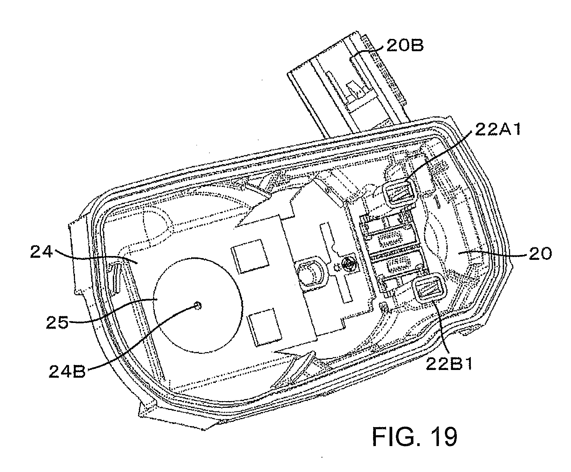

   Fig. 19 is an overall perspective view of the inductive rotation angle sensor according to the third embodiment (after an additional process).
[Fig. 20]

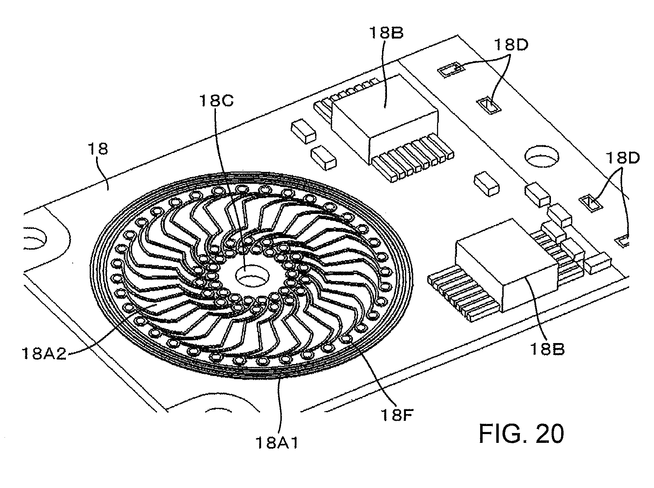

   Fig. 20 is an enlarged perspective view of a TPS substrate.
[Fig. 21]

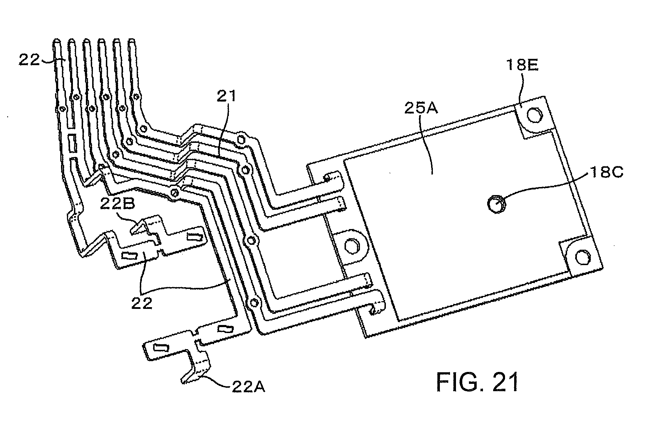

   Fig. 21 is an overall perspective view of a sub-assembly of a TPS substrate and terminals according to a fourth embodiment (a rear surface).
[Fig. 22]

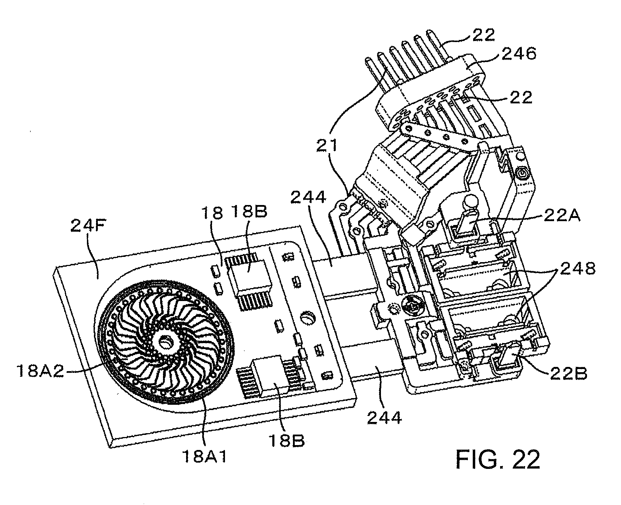

   Fig. 22 is an overall perspective view of an insert molded product according to the fourth embodiment (a front surface).
[Fig. 23]

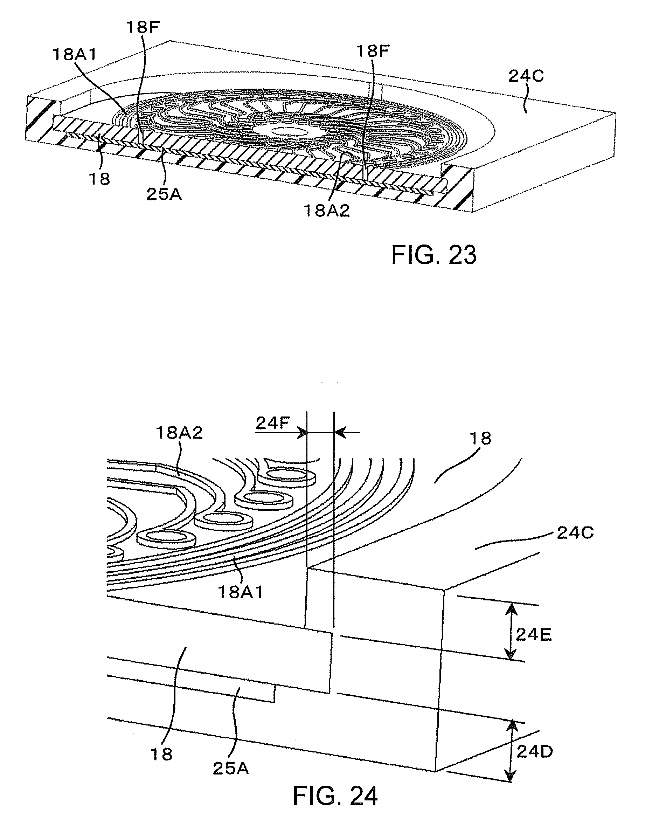

   Fig. 23 is a cross-sectional view of the insert molded product according to the fourth embodiment.
[Fig. 24]
   Fig. 24 is an enlarged cross-sectional view of the insert molded product according to the fourth embodiment.
[Fig. 25]

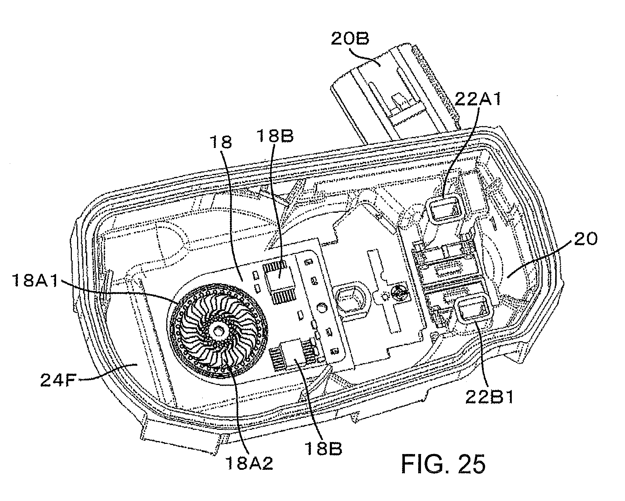

   Fig. 25 is an overall perspective view of an inductive rotation angle sensor according to the fourth embodiment.

### Mode for Carrying Out the Invention

Embodiments of the present invention will hereinafter be described with reference to the drawings.

### Embodiment 1

A configuration of a motor-driven throttle valve unit for an internal combustion engine according to the present embodiment will described with reference to Figs. 1 and 2.

Fig. 1 is an overall cross-sectional view of a motor-driven throttle valve unit (hereinafter abbreviated as the ETB). Fig. 2 is an exploded front view.

An aluminum die-cast throttle assembly (hereinafter referred to as the throttle body) is formed integrally with an air intake passage 1 (hereinafter be referred to as the bore) and a motor housing 2A for housing a motor 2.

A metallic rotating shaft (hereinafter referred to as the throttle shaft) is disposed in the throttle body 3 along a diameter line of the bore 1. The throttle shaft 4 is rotatably supported at its both ends by bearings such as needle bearings 5, 6, ball bearings or other bearings. The needle bearings 5, 6 are fixedly press-fitted to the throttle body 3. A C-shaped washer (hereinafter referred to as the thrust retainer) is inserted into a slit portion provided on the throttle shaft 4. Thereafter, the needle bearing 5 is press fitted to the throttle body 3, thereby restricting the axial movement amount of the throttle shaft 4.

To the throttle shaft 4 is attached a throttle valve 8 to change an amount of air fed to an engine.

With such a configuration, the throttle shaft 4 is turned to turn the throttle valve 8, which consequently changes the opening area of the intake passage, thereby making it possible to regulate the amount of intake air for an internal combustion engine.

A throttle gear 10 is secured to an end of the throttle shaft 4 by means of a nut 11. The throttle gear 10 is composed of a metal plate 10A and a gear portion 10B resin-molded on the metal plate 10A.

The motor housing 2A is formed in parallel with the throttle shaft 4. A brush type DC motor 2 is inserted into the motor housing 2A and secured to it by means of screws 12. A metal gear (hereinafter be referred to as the motor gear) having the smallest number of teeth is secured to the end of the rotating shaft of the motor 2.

A gear (hereinafter referred to as the intermediate gear) is rotatably supported by a metallic shaft 14 (hereinafter referred to as the intermediate gear shaft) fixedly press-fitted to the throttle body 3. The intermediate gear 15 is disposed between and meshed with the motor gear 13 and the throttle gear 10. The intermediate gear 15 has a large-diameter gear 15A meshed with the motor gear 13 and a small-diameter gear 15B meshed with the throttle gear 10. Both the gears are integrally molded by resin molding.

These gears 13, 15A, 15B, 10 constitute a two-stage reduction gear mechanism. Thus, the rotation of the motor 2 is transmitted to the throttle shaft 4 via the reduction gear mechanism.

A return spring 16 composed of a helical spring is held between the rear surface of the throttle valve 10 and a side surface of the throttle body 3. The return spring 16 is retained at one end by a notch formed on the throttle body 3 and at the other end by a notch formed on the throttle gear 10. The return spring 16 is subjected to a pre-load in a rotational direction so that the throttle valve 8 may be kept at a fully opened position during the non-energization of the motor 2.

A description is next given of a method of mounting the inductive rotation angle sensor with reference to Figs. 3 and 4.

Fig. 3 is a partial cross-sectional view of a rotating conductor of the inductive rotation angle sensor. Fig. 4 is an exploded perspective view of the rotating conductor.

As described earlier, the inductive rotation angle sensor is composed of the conductor attached to the rotating shaft of the rotary member and the conductor attached to the stator opposed thereto. The former conductor corresponds to a disk plate (hereinafter referred to as the rotor) shown in Figs. 3 and 4 and the latter conductor corresponds to a circuit substrate (hereinafter referred to as the TPS substrate).

An excitation conductor 17A is printed on the rotor 17. The rotor 17 is fixedly bonded to a cup-like holder (hereinafter referred to as the rotor holder) formed of a resin molding. A metallic rotor holder inserter 19A is integrally formed at the central portion of the rotor holder 19. A through hole 17B for positioning is formed at the center of the rotor 17. A projecting portion 19B for positioning is formed on the rotor holder inserter 19A so as to correspond to the through hole 17B. In this way, the central axes of the rotor 17 and the rotor holder 19 are aligned with each other. An annular window-hole 19C is provided on the central axis of the rotor holder inserter 19A. The window-hole 19C is fixedly press-fitted to the throttle shaft 4. Accordingly, the rotor 17 is rotated similarly to the throttle shaft 4.

A component configuration of the present embodiment is specifically described with reference to Fig. 5. Fig. 5 is a perspective front view of the inductive rotation angle sensor (hereinafter, "the TPS" means "the rotation angle sensor").

An annular excitation conductor 18A1 and a plurality of detection conductors 18A2 arranged in a radial direction are printed on the TPS substrate 18. These conductors serve as an electric source section for driving a rotational position (angle) detecting section and the rotational position (angle) detecting section. The TPS substrate 18 has thereon an electronic circuit element 18B including a micro computer. The present circuit performs drive control and output signal processing of the rotation angle detecting section. The TPS substrate 18 is mounted inside a cover (hereinafter referred to as the gear cover) of a resin molding.

Six metallic wiring conductors are installed inside the gear cover 20. The six wiring conductors are broadly divided into four TPS wiring conductors 21 and two motor wiring conductors 22. The ends of the wiring conductors are collected by a connector 20B formed on the gear cover 20. When the rotation angle sensor is mounted on a vehicle, electric wires extending from an engine control unit are joined to the above-mentioned connector 20B via an attachment plug; thereby the transmission and reception of electric signals, supply of electric power, and connection to a grounding wire are implemented. Before exterior molding (referred to as overmolding) will be performed, the metallic wiring conductors are insert molded (referred to as pre-molding) to make the positions of the wiring conductors accurate. In this case, also the TPS substrate 18 to be attached inside the gear cover 20 is insert molded together with the wiring conductors. Insert molding is described later with other figures.

A method of connecting the TPS substrate 18 with the TPS wiring conductors 21 is next described with reference to Figs. 6 to 9. Fig. 6 is an overall perspective view of the TPS wiring conductors 21. Fig. 7 is an enlarged view of the ends of the TPS wiring conductors 21. Fig. 8 is an overall perspective view of the TPS substrate 18. Fig. 9 is an enlarged view of a connection.

Before the TPS wiring conductors 21 and the TPS substrate 18 will be insert molded simultaneously, four TPS wiring conductors 21 are previously electrically connected to the TPS substrate 18. To establish the electrical connection, a metallic member is disposed on the inner wall of each of wiring through holes 18D provided on the TPS substrate 18. Connection terminals 21A of the TPS wiring conductors 21 on the side opposite the connector are each squeezed, with pressurization, into a corresponding one of the wiring through holes 18D provided on the TPS substrate 18. The TPS wiring conductors 21 have an elastic structure. In this case, the wiring conductor having a size larger than the inside dimension of the wiring through hole 18D is pressurized. A bulging portion (having an oval hole at its center) provided in the connection terminal 21A is compressed. The TPS substrate 18 and the TPS wiring conductors 21 are pressure welded (hereinafter referred to as the press-fit connection) by the spring force at this time. Thus, electrical continuity is established therebetween. A falling-off prevention stopper 21B is formed on the connection terminal 21A of the TPS wiring conductor 21 on the side opposite the connector. This prevents the TPS wiring conductor 21 having once been connected to the TPS substrate 18 from falling off from the wiring through hole 18D on the TPS substrate. Since the connection terminal 21A is made to have an elastic shape, the connection terminal 21A may have vibration resistance and also can be protected from shearing stress caused by resin flow during insert molding. Since the press fit connection is performed, it is not necessary to prepare another metallic conductor used to connect the TPS wiring conductors 21 with the TPS substrate 18, and this leads to a cost reduction. Also when the TPS wiring conductors 21 and the TPS substrate 18 are connected to each other, they do not have to be heated such as soldering but can be connected to each other at ordinary temperatures. Thus, design for thermal influence such as soldering is not needed and energy saving connection using no electricity can be achieved.

When the TPS wiring conductors 21 are connected to the TPS substrate 18 in the press fit structure, such connection is mechanical connection by a spring force. Therefore, the spring force is constantly exerted on the TPS substrate 18. With that, to distribute the direction of the force exerted on between the wiring through holes 18D, adjacent to each other, of the TPS substrate 18, the fastening directions of the press fit structure are set alternately. Thus, a mechanical load exerted on the TPS substrate 18 can be reduced, so that it is not necessary to use a substrate of an expensive high-strength material, which leads to a cost reduction. Incidentally, a connection terminal 22A of the motor wiring conductors 22 on the side opposite the connector projects from the gear cover. As shown in Fig. 10, the connection terminal 22A establishes electrical connection with a connection terminal 22B projecting from the motor 2 side via a relay coupling 23 at resin-molded portions 22A1, 22B1. Insert molding is next described.

Fig. 11 is an overall perspective view showing a sub-assembly state of the TPS substrate 18, the TPS wiring conductors 21 and the motor wiring conductors 22. The insert molding is performed after the TPS substrate 18, the TPS wiring conductors 21 and the motor wiring conductors 22 are brought into the state shown in Fig. 11 and set in a mold.

Because of being installed in an engine room, the ETB is put under high- and low-temperature environments. Therefore, polybutylene-telephthalate (PBT) having satisfactory heat resistance and general versatility is used as resin used for the external molding of the gear cover 20. (In the present embodiment the material for the gear cover is hereinafter described as the PBT.) To keep component parts inexpensive, it is desirable to use a PBT resin having good distributability in the market and general versatility for insert molding. The use of such a PBT resin does not debase production takt time resulting from the use of a special resin material and require expensive and complicated design of a mold. Thus, the ETB can be manufactured inexpensively in a comprehensive way. However, if insert molding including an electronic substrate is performed using a thermoplastic PBT material, then mold injection is carried out at elevated temperature and pressure. Therefore, electronic components mounted on the upper surface of a substrate are likely to be damaged by heat or shearing stress occurring during flow.

In the meanwhile, in the case of mounting the TPS substrate 18 in resin, if the resin covering the TPS substrate 18 is thick, then the distance between the excitation conductor 17A of the rotor 17 and the excitation conductor 18A1 and the detection conductors 18A2 on the TPS substrate is increased by the thickness of the resin. Thus, the function and accuracy as the inductive rotation angle sensor cannot be achieved. Receiving sensitivity can be increased by enlarging the inductive rotation angle sensor. However, the TPS substrate to be mounted is enlarged; therefore, component parts cannot be collected in a compact manner. Thus, it is necessary to reduce the thickness of the resin on the upper surfaces of the excitation conductor 18A1 and the detection conductors 18A2 on the TPS substrate.

However, if the thickness of the resin on the upper surfaces of the excitation conductor 18A1 and the detection conductors 18A2 is to be reduced, the flow of the resin slows. Therefore, it is necessary to increase molding pressure. However, if the molding pressure is increased, electronic components are likely to be damaged due to the resin pressure during molding.

In the present embodiment, the molecular weight of a PBT resin is adjusted to increase its fluidity. Alternatively, additives are added to the PBT resin. Accordingly, the molding resin made of PBT resin material is provided that can be molded at low pressures and has high fluidity. The resin thus selected is not limited to the PBT resin. An overmold resin used to form the gear cover can be selected from thermosetting or thermoplastic resins depending on the nature of the overmold resin.

If a PBT material containing a low-melting point polymer material is used, the PBT material can be molded at a temperature lower than a resin molding temperature required during normal resin molding. Therefore, any damage to a circuit component and a solder joint portion due to the temperature of resin can be alleviated. Thus, it is possible to insert mold the whole circumference of the circuit substrate (the excitation conductors 18A1, the detection conductors 18A2, the electronic circuit elements 18B and the wiring conductors 21, 22).

Fig. 12 shows a gate position encountered when insert molding is performed.

When insert molding is to be performed, to prevent the deformation of the TBS substrate 18 due to resin pressure, the gate position for resin is set at a side gate position 24A so as to permit the resin to flow in parallel to the longitudinal direction of the TPS substrate 18. Fig. 12 shows one side of lateral surfaces of the TPS substrate 18 as the side gate position 24A by way of example. However, even if the gate position for resin is set at one of the other three sides, the same effect can be produced. The side gate position 24A shown in Fig. 12 is close to the excitation conductor 18A1 and the detection conductors 18A2 on the TPS substrate. Therefore, the molding resin made of the PBT resin material that can be molded at low pressure and has high fluidity is poured. This facilitates to form a thin disk-like layer (a resin film layer) 25 at the excitation conductor 18A1 and the detection conductors 18A2 on the TPS substrate. The molding resin flows from both sides of the thin disk-like layer (the resin film layer) 25 toward the electronic circuit element 18B, the electric connection 18C between the TPS substrate and the wiring conductors and the wiring conductors 21, 22. Thus, the molding resin forms a motor relay terminal portion 24B and finally reaches the terminal portion of the connector. Reference numeral 242 denotes a molding portion of the electronic circuit element 18B and 244 denotes a molding portion of the electric connection 18C between the circuit substrate and the electric conductors. Reference numeral 246 denotes a molding portion of the wiring conductors 21, 22 of the connector portion and 248 denotes molding portions of the connection terminals 22A, 22B of the motor.

As described above, the present embodiment is characterized by the following configuration. A portion corresponding to the excitation conductor 18A1 and the detection conductors 18A2, the electronic circuit elements 18B, the electric connection between the electronic circuit substrate and the wiring conductors, a part of the wiring conductors 21, 22 of the connector portion, and the connection terminal 22A with the motor are previously covered with resin through resin molding. The electronic circuit substrate including the excitation conductor 18A1 and the detection conductors 18A2 and the wiring conductors (21, 22) are formed as a single molded body. Consequently, when the resin-made gear cover for the motor-driven throttle valve unit or the inductive rotation angle sensor is automatically assembled on a line, welding or soldering work for the wiring conductors is eliminated, which improves assembly performance.

Also a process for bonding the electronic circuit substrate to the resin-made gear cover is eliminated. Therefore, an assembly time can be shortened for the time taken for drying an adhesive.

Since an adhesive is not used, the dimension between an attachment surface of the resin-made gear cover to the throttle body and the excitation conductor 18A1 and the detection conductors 18A2 can be determined accurately through the resin molding.

More specifically, if the adhesive is used, the dimension between the electronic circuit substrate and the attachment surface of the resin-made gear cover probably varies depending on the amount of the adhesive for each product. Such variability changes also depending on the dried state of the adhesive; therefore, it is difficult to manage the variability.

In the present embodiment, the dimension between the attachment surface of the resin-made gear cover 20 to the throttle body 3 and the excitation conductor 18A1 and the detection conductors 18A2 is managed by a jig during resin molding. Therefore, the same dimension between the attachment surface of the resin-made gear cover 20 to the throttle body 3 and the excitation conductor 18A1 and the detection conductors 18A2 can be shared by all products. Thus, the same magnetic gap (the detection gap) encountered when the gear cover 20 is assembled to the rotor 17 can be shared by all products. Consequently, magnetic property as the inductive rotation angle sensor will not vary depending on products.

Positioning of an insert molded product 24 during exterior molding (overmolding) is next described with reference to Fig. 12.

When the exterior molding (overmolding) of the gear cover is performed with the insert molded product 24 used as an insert component, positioning of the insert molded product 24 with respect to the TPS substrate 18 is needed. To satisfy a sensing function, it is necessary that the rotor 17 and the through hole 18C bored at the central portion of the TPS substrate 18 are located coaxially with each other. During insert molding, a die having the same diameter as the through hole 18C is put in the through hole 18C of the TPS substrate to block off the inflow of resin to such a portion. This forms the insert molded product 24 with a positioning hole 24B having the same diameter as the through hole 18C of the TPS substrate. This hole is used as a positioning hole to be used during exterior molding. Therefore, accurate and easy positioning becomes possible. Thus, the exterior molded product as shown in Fig. 13 is completed.

The present embodiment has described the processes for performing the insert molding (primary molding: referred to as pre-molding) and the exterior molding (secondary molding: also referred to as overmolding). However, it is possible that the TPS substrate 18, the TPS wiring conductors 21 and the motor wiring conductors 22 are brought into the sub-assembled state and thereafter the gear cover is manufactured by single molding.

In this case, the excitation conductor 18A1 and the detection conductors 18A2, the electronic circuit elements 18B, the electric connection between the TPS substrate and the wiring conductors, the TPS wiring conductors and motor wiring conductors of the connector portion, and the connection terminal 22A of the motor are set in a molding jig and molded by the molding resin of the resin-made gear cover. The TPS substrate including the excitation conductor 18A1 and the detection conductors 18A2 and the wiring conductors (21, 22) are formed as a single molded body. In the case configured as described above, the molding process is needed only once; therefore, assembly performance is further improved.

### Embodiment 2

Another embodiment is described with reference to Figs. 14, 15 and 16.

Fig. 14 is an overall perspective view of a sub-assembly of the TPS substrate and the wiring conductors. Fig. 15 shows a shape after the sub-assembly has been insert molded. Fig. 16 is an overall perspective view of a complete product after exterior molding.

Embodiment 1 is an example in which the overall substrate is covered by a high fluidity resin and the resin on the upper surfaces of the excitation conductor 18A1 and the detection conductors 18A2 on the TPS substrate is thinly molded. As shown in Fig. 14, before insert molding, the same resin film 25A as the resin material used during the insert molding is applied to the upper surface of the excitation conductor 18A1 portion on the TPS substrate. Thus, the same object can be achieved by performing the insert molding 24 as well. The resin film 25A uses the same resin material as that used during the insert molding 24. Therefore, it is possible to prevent the occurrence of deformation or crack due to a difference in linear expansion coefficient or the like after the molding. The resin film 25A that skirts around the positioning hole 24B used during exterior molding is applied to the upper surface of the excitation conductor 18A1. Thus, the center of the TPS substrate can be positioned accurately during the exterior molding.

### Embodiment 3

Another embodiment is described with reference to Figs. 17, 18 and 19.

Fig. 17 is an overall perspective view of an insert molded product 24 in which the overall TPS substrate is covered by resin. Fig. 18 shows a shape after exterior molding (overmolding). Fig. 19 is an overall perspective view in which the thickness of resin on the upper surface of an excitation conductor 18A on the TPS substrate is reduced by additional processing.

In the present embodiment, when the excitation conductor 18A1 and the detection conductors 18A2 on the TPS substrate are insert molded 24, the overall TPS substrate 18 is covered by resin with uniform thickness. This can compensate for the deformation of the substrate resulting from the shrinkage of resin, so that deformation and strain after the molding can be minimized as much as possible. After the exterior molding (overmolding) has been performed, a resin portion covering the excitation conductor 18A1 and the detection conductors 18A2 is chipped off by cutting work to a position (depth) where the TPS substrate 18 and the rotor 17 do not come into contact with each other. Thus, the TPS substrate 18 and the rotor 17 are brought into close to each other to satisfy a sensing function. The additional processing area to be processed has a diameter greater than that of the rotor 17.

Incidentally, in place of the cutting work, the following process may be available. During exterior molding, an insert molded product is heated to be softened. In this state, a resin portion covering the excitation conductor 18A1 and the detection conductors 18A2 can be thinned by press molding. This method has an effect of eliminating the removal of chips.

### Embodiment 4

Another embodiment is described with reference to Figs. 20 to 25.

In the present embodiment, during insert molding, a frame-like layer 24C in which resin covers only the circumference of a TPS substrate is provided so that the resin does not cover electronic components mounted on the TPS substrate 18 and an excitation conductor 18A1 and detection conductors 18A2 on the TPS substrate. With the present embodiment configured described above, the excitation conductor 18A1 and the detection conductors 18A2 are naked. Therefore, when the TPS substrate 18 is assembled to the rotor 17, a detection gap between the excitation conductor 17A and the excitation conductor 18A1 and the detection conductors 18A2 can be more reduced to improve the detection accuracy of the TPS. Incidentally, during the insert molding, molding resin may probably overflow from the rear side to front side of the TPS substrate 18 via through-holes 18F in the present embodiment. The overflowing molding resin differs from one another in quantity depending on the through-holes 18F. Consequently, the detection gap between the excitation conductor 18A1 and the detection conductors 18A2, and the rotor side conductor is likely not to be reduced. Therefore, as an improved technique a resin film 25A is attached on the rear side of the TPS substrate 18 as shown in Fig. 23 and then resin is molded in a frame-like manner. With this configuration, the molding resin will not overflow from the rear side to front side of the TPS substrate 18 via the through-holes 18F. Thus, the above-mentioned problem can be solved.

Fig. 20 is an enlarged perspective view of the TPS substrate. Fig. 21 is an overall perspective view showing the rear sides of the TPS substrate and the wiring conductors which are pre-assembled. The above-mentioned technique is described further in detail.

As shown in Fig. 20, the TPS substrate 18 has the through holes 18F. Resin may flow into these gaps and cure therein after molding. In such a case, the resin having entered the TPS substrate 18 and the through-holes 18F may probably cause cracks due to a difference in the linear expansion coefficient of the resin. To prevent the occurrence of the cracks, before insert molding, the resin film having the same material as that used during insert molding is attached to the rear surface 18E of the TPS substrate to cover the through-holes 18F as shown in Fig. 21. Thus, the resin is prevented from entering the through-holes 18F during the insert molding 24.

Fig. 22 is an overall perspective view showing the TPS substrate whose outer circumference is insert molded. Fig. 23 is a cross-sectional view of the TPS substrate part of Fig. 22. Fig. 24 is an enlarged view of Fig. 23.

If only one surface of the TPS substrate 18 is insert molded, materials different in linear expansion coefficient from each other are integrally molded. After molding shrinkage, deformation or camber occurs to produce residual stress, which leads to the crack of the resin. To suppress the molding shrinkage, as shown in Fig. 25, the outer circumference of the TPS substrate 18 is covered by resin. In addition, a thickness 24E of resin on the upper surface of the TPS substrate is set equal to a thickness 24D of resin on the lower surface thereof. Accordingly, shrinkage of the resin on the upper surface of the substrate and that on the lower surface of the substrate can be cancelled out. This process serves as a measure to prevent the deformation and the camber. To prevent the occurrence of burrs on the upper surface of the TPS substrate 18 after the insert molding, the area of frame insert molding 24C surrounding the outer circumference of the TPS substrate is set to an area 24F as below and molding is performed. The area 24F avoids the positions of electronic components mounted on the upper surface of the substrate and the position of the sensing portion on the upper surface of the TPS substrate. In addition, the area 24F is where the TPS substrate 18 and the resin of the frame insert molding 24C overlap each other.

The embodiments described above are organized as below.

### <Embodiment 1>

In an electronic control throttle body subjected to feedback control by an actuator and a position sensor,
a rotation angle sensor including:
   a case member covering a rotation detected member and having a case member attached with a substrate;
   an excitation conductor portion disposed annularly on the substrate and producing an magnetic field through application of an electric current;
   an excitation conductor portion secured to the rotation detected member, disposed in a non-contact state with the excitation coil portion with an interval kept therebetween, and producing an electric current in accordance with the rotational position of the rotation detected member through electromagnetic action;
   a reception conductor portion disposed on the substrate and producing an electric current corresponding to an electric current flowing in the excitation conductor;
   a gear installed between the motor and a throttle valve in order to reduce the power of the motor; and
   a shaft functioning as a rotating shaft of the gear; and
a throttle valve unit being such that
   the substrate and a terminal disposed inside the case are previously electrically coupled to each other before molding of the case member, and
   the substrate and the terminal are covered by the same material as that forming the case.

### <Embodiment 2>

The throttle valve unit recited in embodiment 1,
wherein a central portion of a rotation detecting portion on the substrate is not covered by resin.

### <Embodiment 3>

The throttle valve unit recited in embodiment 1,
wherein the substrate and a terminal disposed inside the case and having an elastic shape at the other end thereof are previously electrically coupled to each other through press fit connection before molding of the case member.

### <Embodiment 4>

The throttle valve unit recited in embodiment 2 or 3,
wherein the substrate and the terminal are mounted by one or more times of molding.

### <Embodiment 5>

The throttle valve unit recited in embodiment 1 or 4,
wherein the whole circumference of the substrate is covered by the case member.

### <Embodiment 6>

The throttle valve unit recited in embodiment 5,
wherein resin in an area of a rotation detecting portion on the substrate is thinner than that on the other case member.

### <Embodiment 7>

The throttle valve unit recited in embodiment 4,
wherein an area excluding the area of a rotation detecting portion on the substrate and an area on which an electronic component is mounted is covered by resin.

### <Embodiment 8>

The throttle valve unit recited in embodiment 7,
wherein before molding, the same resin film as the case member is attached to a rear surface of the substrate covered by the case member, the rear surface being opposite the electronic component and the excitation conductor portion mounted on an upper surface of the substrate.

### Industrial Applicability

The present embodiments describe the inductive non-contact rotation angle sensor and the throttle valve unit driven by a motor of an internal combustion engine equipped with the sensor. However, the present invention can be applied to any equipment in which a circuit substrate having an electronic component is mounted on a cover member.

In addition, the present invention can be applied also to a motor-driven throttle unit of an internal combustion engine having two default mechanisms.

### Description of Reference Numerals

- 1: Bore
- 2: Motor
- 2A: Motor housing
- 2B: Terminal on the motor
- 3: Throttle body
- 4: Throttle shaft
- 5, 6: Needle bearing
- 7: Thrust retainer
- 8: Throttle valve
- 9, 12: Screw
- 10: Throttle gear
- 10A: Throttle gear metal plate
- 10B: Gear portion of the throttle gear
- 11: Nut
- 13: Motor gear
- 14: Intermediate gear shaft
- 15: Intermediate gear
- 15A: Large-diameter gear portion
- 15B: Small-diameter gear portion
- 15C: Intermediate gear boss portion
- 16: Return spring
- 17: Rotor
- 17A: Excitation conductor
- 17B: Positioning through-hole
- 18: TPS substrate
- 18A1: Excitation conductor
- 18A2: Detection conductor
- 18C: Through hole
- 18D: Wiring through hole
- 18E: Rear surface of the TPS substrate
- 18F: Through hole
- 19: Rotor holder
- 19A: Rotor holder inserter
- 19B: Projecting object for positioning
- 19C: Annular window hole
- 20: Gear cover
- 20A: Projecting object for positioning
- 20B: Connector
- 20C: Boss for the intermediate gear
- 20D: Boss portion for the intermediate gear
- 21: TPS wiring conductor
- 21A, 22A: Connection terminal
- 21B: Falling-off prevention stopper
- 22: Motor wiring connection
- 23: Relay coupling
- 24: Insert molded product
- 24A: Side gate position
- 24B: Positioning hole
- 24C: Frame-like layer
- 24D: Thickness of resin on the lower surface of the TPS substrate
- 24E: Thickness of resin on the upper surface of the TPS substrate
- 24F: Area where the TPS substrate and resin overlap each other
- 25: Layer (resin film layer) on a disk
- 25A: Resin film
- 26: Sensing portion additional process portion

## Claims

1. An inductive non-contact rotation angle sensor comprising:
a rotary conductor attached to a rotating shaft of a rotary member;
a stationary conductor attached to a resin cover member opposed to the rotary conductor; and
an electronic circuit for detecting a rotational position of the rotary member by utilizing changes in the inductance between both the conductors according to a positional relationship between both the conductors in a rotational direction;
wherein the resin cover includes a circuit substrate to which the stationary conductor and the signal processing circuit are attached, a connector for electrically connecting with external equipment and an electric conductor connecting a connector terminal formed on the connector with the circuit substrate; and
wherein at least a part of the circuit substrate and the electric conductor are formed as a single molded body molded by the same resin.

2. The inductive non-contact rotation angle sensor according to claim 1,
wherein the stationary conductor secured to the circuit substrate and the electric conductor are formed as a single molded body covered and molded by the same resin, and
wherein the molded body is further overmolded by a molding resin of the resin cover having the connector.

3. The inductive non-contact rotation angle sensor according to claim 1 or 2,
wherein an electric connection between the circuit substrate and the electric conductor is covered and molded by the same resin as the molded body or the resin cover.

4. The inductive non-contact rotation angle sensor according to claim 3,
wherein a resin layer covering the stationary conductor is formed to have a thickness smaller than the thickness of a resin layer covering the electric conductor.

5. The inductive non-contact rotation angle sensor according to any one of claims 1 to 4,
wherein an electric connection between the circuit substrate and the electric conductor is connected by pressure welding (press fit).

6. A motor-driven throttle valve control unit equipped with the inductive non-contact rotation angle sensor according to any one of claims 1 to 5,
wherein a relay terminal for power supply to the motor is molded by the same molding resin as a molding resin of the resin cover and an electric conductor for power supply to a motor is formed as a single molded body together with the circuit substrate and another electric conductor.

7. The motor-driven throttle valve control unit according to claim 6,
wherein the resin cover functions as a housing member housing a gear mechanism for transmitting the rotation of the motor to the throttle valve.

8. The motor-driven throttle valve control unit according to claim 6,
wherein the rotary conductor is attached to the throttle valve shaft or a throttle gear secured to the throttle valve shaft.
